(19) Europäisches Patentamt
European Patent Office
Office européen des brevets

(11) Publication number: **0 313 221 B1**

(12) **EUROPEAN PATENT SPECIFICATION**

(45) Date of publication of patent specification: **04.05.94** (51) Int. Cl.5: **G03F 7/12**

(21) Application number: **88308826.2**

(22) Date of filing: **22.09.88**

# (54) Photostencils for screenprinting.

(30) Priority: **17.10.87 GB 8724372**
**24.02.88 GB 8804278**

(43) Date of publication of application:
**26.04.89 Bulletin 89/17**

(45) Publication of the grant of the patent:
**04.05.94 Bulletin 94/18**

(84) Designated Contracting States:
**BE CH DE FR GB IT LI LU NL SE**

(56) References cited:
**EP-A- 0 130 804**
**GB-A- 2 076 826**

**PATENT ABSTRACTS OF JAPAN vol. 8, no. 109 (P-275)(1546) 22 May 1984, & JP-A-59 17550**

(73) Proprietor: **AUTOTYPE INTERNATIONAL LIMITED**
**Grove Road**
**Wantage Oxfordshire OX12 7BZ(GB)**

(72) Inventor: **Balfour, Ross Alexander**
**36 Mallard Way**
**Grove Wantage Oxfordshire OX12 OOO(GB)**
Inventor: **Sperry, John Arthur**
**41 Norman Avenue**
**Abingdon Oxfordshire OX14 2HJ(GB)**

(74) Representative: **Ackroyd, Robert et al**
**W.P. THOMPSON & CO.**
**Eastcheap House**
**Central Approach**
**Letchworth, Hertfordshire SG6 3DS (GB)**

EP 0 313 221 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to photodimerisable polymer compositions used in the manufacture of printing screens. More particularly, it is concerned with a screenprinting photostencil having a coating layer comprising a photosensitive emulsion containing a particular photodimerisable derivative of polyvinylalcohol.

In the preparation of screens for the screenprinting process, water-soluble and water-processable resist materials are very desirable, because of their cheapness and safe handling properties, at the manufacturing stage, and the subsequent ease of processing after image-wise exposure. Further, it is very desirable to be able to recover the expensive mesh support easily, after each printing run, so that it may be used repeatedly. Polyvinylalcohol and mixtures containing it are widely used in this application, because it has the distinct advantages of being water-soluble, and of having good resistance to ink-solvents. Moreover, the hardened resist derived from such materials can easily be recovered after the print run by the application of an aqueous periodate solution, as described in GB-A-1,375,402.

Mixtures of polyvinylalcohol and polyvinylacetate dispersions are commonly used and may be rendered light-sensitive by the inclusion of dichromate salts or so- called "diazo-resins". In practice, dichromate salts are rarely used nowadays, because of their toxicity and the difficulty of disposing of effluents containing heavy metals. Also, dichromate-sensitised emulsions undergo a "dark" reaction, which gives these products a very limited shelf-life. Diazo resins are condensation products, usually derived from diazodiphenylamine and formaldehyde, and are used in a metal-free form. When mixed with a solution of polyvinylalcohol, diazo resins give an excellent resist, but photographically it is rather slow and has a limited shelf-life, particularly in the presence of water. Free radical systems are also used for the purpose of sensitising these dispersions, as disclosed in GB-A-2,108,986, GB-A-2,109,392, GB-A-2,137,626 and GB-A-2,108,979. These generally consist of:

(i) a photoinitiator, which under the effect of actinic light produces free radicals capable of initiating vinyl polymerisation;

(ii) a monomer, usually containing two or more unsaturated groups which are capable of polymerisation; the effect of more than one unsaturated group is to enable cross-linking to occur, which increases the efficiency of the hardening reaction;

(iii) a suitable water-processable colloid; the efficiency of the reaction can be greatly enhanced if the colloid contains substituents which enable the polymer chains actually to take part directly in the reactions involved, rather than simply becoming enmeshed in a matrix of cross-linked monomer.

The disadvantages of the latter procedures are that free radical systems are intrinsically oxygen-sensitive and also they require a carefully-controlled moisture level, presumably to optimise the mobility of the component parts of the system to obtain the best photographic speed. This necessarily means that the photographic speed will vary as the moisture content changes. Recent patent specifications have described photodimerisable systems, which combine the advantage of participation in the photoreaction, by the substituted polymer chains themselves, with fast photographic speeds and great thermal stability. GB-A-2030575, GB-A-2076826 and J Polymer Sci., Polymer Chem, Edn. 1980, 18. 891-902, describe products produced by causing a styryl-pyridine salt prossessing a formyl group or an acetal group to react with polyvinylalcohol. The resulting polymer is completely water-soluble and has a very high photo-activity, due to alignment of the reactive groups, which imparts very high photo-activity even at low levels of substitution, and results in a greatly improved photographic speed. Its use in the preparation of screen printing resists is disclosed in JP-B-65-40814 and EP-A-0130804.

EP-B-0092904 describes a similar system, but the active group is a chalcone, CO-CH = CH-, rather than a stilbazole; chalcones are more easily prepared, but are not as efficient in the photoreaction as the corresponding stilbazoles. We have now discovered a photodimerisable resin composition which is highly suitable for use as a screen stencil resist and which has a high photoactivity.

JP-A-59-1750 discloses derivatives of polyvinylalcohol having a structural unit of the formula

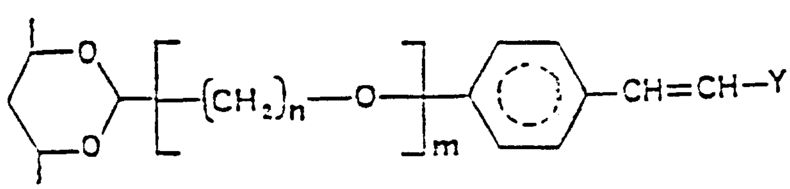

wherein n = 1 and m = 0 or 1 and Y is a quaternized benzothiazole group, or the naphthalene-based analogue of a quaternized benzothiazole group.

According to one aspect of this invention, a screenprinting photostencil is provided which comprises a support layer and a coating layer comprising a photosensitive emulsion containing a photodimerisable polyvinylalcohol derivative which incorporates a photosensitive constituent of the formula:

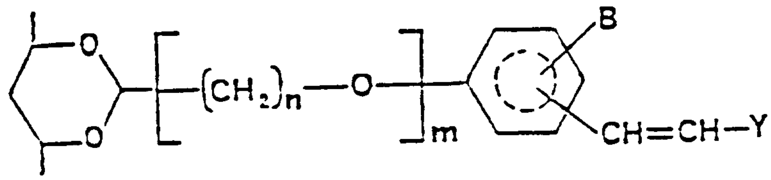

wherein

Y = 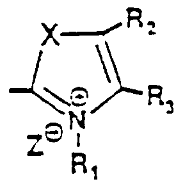 or 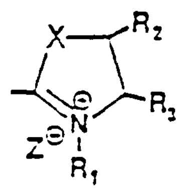

m = 0 or 1;
n = 0 or an integer from 1 to 6; subject to the proviso that when n = 0, then m = 0;
B = H or a tertiary amine, methoxy or ethoxy group;
X = 0, S or Se or an $NR_1$ or $C(R_1)_2$ group,
wherein $R_1$ = H or an alkyl, hydroxyalkyl, aryl or aralkyl group,
Z = an anion and

$R_2$ and $R_3$ are the same or different and each represents H, halogen or an alkyl, hydroxyalkyl, aryl, nitro or cyano group or $R_2$ and $R_3$ taken together may form part of the same aliphatic ring system.

It has been established that systems based upon these photosensitive polymer compositions alone give good stencils which are resistant to solvent-based inks.

According to a preferred and important feature of the invention, the photosensitive emulsion also contains a filler, comprising of one or more of polyvinylacetate, polyethylene vinylacetate, polyacrylates, polystryrene, polybutadiene and polyvinylchloride.

An important aspect of the invention is the discovery that photosensitive compositions which include one or more of the polyvinylalcohol derivatives of the above formula and one or more of these polymeric fillers indicated above give photostencils which have improved printing properties. If the ratio of filler to photopolymer is increased, it has been found that compositions having increasing resistance to water are produced, but at the expense of poorer solvent resistance and poorer mesh recovery properties.

Water-based inks containing some organic solvent are now becoming of increasing commercial importance, due to pressure to reduce the amounts of solvents emitted to the atmosphere, and the greater safety which such inks offer. Both of the stencil systems so far described, based upon polyvinylalcohol derivatives of the above formula, optionally with fillers of polymeric materials, produce excellent stencils. However, neither of these types of stencil systems is able to withstand these aggressive water-based solvent-containing inks.

According to a further preferred and important feature of the invention, based upon this additional discovery, the polymer composition as defined above, optionally in conjunction with a polyvinylacetate or other polymeric filler also as defined above, is associated with a photoinitiator of a kind which, under the effect of actinic light, produces free radicals capable of initiating vinyl polymerisation, together with a monomer containing two or more unsaturated groups capable of polymerisation. Surprisingly, stencils so formed are still capable of normal development and, at the end of the print run, may be easily removed from the mesh by the application of a solution of periodate salts.

The polyvinylalcohol derivative of the photostencil of the invention can be prepared by a process in which polyvinylalcohol is heated under acid conditions with at least one compound of the general formula:

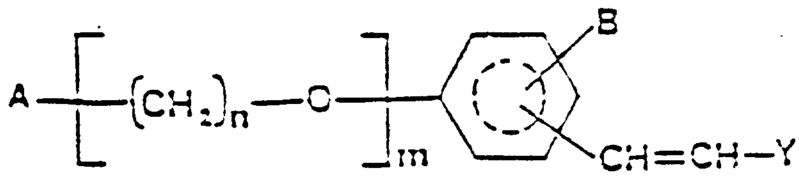

where A is a formyl or acetal group and m,n,B and Y have the meanings defined above. The reaction is preferably carried out at a pH in the range from 1.0 to 4.0 and most preferably the pH used for the reaction is about 2.0. More than one of the intermediates having the general structure described above, but not having the same structure, may be admixed.

The properties of the photopolymer may be further modified by the inclusion in the reaction mixture of non-light-sensitive compounds containing a formyl or acetal group; these also condense during the reaction and may be used to change such properties as solubility in defined solvents, adhesion to various substrates or abrasion-resistance. Examples of such non-light-sensitive modifiers include benzaldehyde or substituted benzaldehydes, acetaldehyde, acetaldehyde-dimethyl or diethylacetal, chloral and chloracetaldehyde-dimethyl or diethyl acetal. The polyvinylalcohol used may be any partially or fully-hydrolysed grade of polyvinylacetate and may, therefore, contain a number of acetyl groups. The photopolymers can be produced by treating the partially or fully-hydrolysed polyvinylalcohol dissolved in a suitable solvent, usually water, with the one or more compounds described above and adding an acid catalyst. Examples of suitable acids include hydrochloric acid, sulphuric acid, phosphoric acid, methanesulphonic acid and p-toluene-sulphonic acid. The reaction may be carried out at a temperature in the range from room temperature (say 20 °C) to 100 °C and at a pH in the range from 1.0 to 4.0. The reaction time is desirably in the range from 2 to 72 hours. The preferred reaction conditions are 70 °C for 4 hours. The photopolymer may be separated by precipitation in a suitable solvent, for example, acetone, or the reaction mixture may be used directly after adjustment of the pH, with a base, by the addition of a suitable filler, such as polyvinylacetate. The emulsion may then be coated directly upon a suitable printing-screen and allowed to dry, or on to a temporary support, such as a suitable film-base. Photopolymers of the above general structure where $R_2$ and $R_3$ form part of a benzene or naphthalene ring and where X is oxygen or sulphur are disclosed in JP-A-59-17550; compounds encompassed by the definition of the above general structure are the subject of our co-pending application of even date (EP-A-0313220). The use of any of the above compounds in the preparation of screenprinting photostencils has not previously been disclosed.

The photosensitive resin compositions herein described have a very high photo-efficiency, enabling thick layers on printing screens to be adequately hardened throughout their total thickness, even when given a relatively short exposure time, i.e. they display considerably greater photographic speed than the systems previously described.

The photosensitive group need be present in only low concentrations, e.g. about 0.46 to 3 mole %, on the polyvinylalcohol to give very high levels of photosensitivity. Because of this, the photopolymer retains many of the useful properties of polyvinylalcohol itself; for example, its resistance to typical ink solvents is maintained and the photocrosslinked resist may be easily removed after use by the application of aqueous periodate salt solutions, as described in GB-A-1,375,402, enabling the very expensive screen-meshes to be easily recovered for reuse at the end of a print-run.

In addition to the various components described above, the screen stencil formulation may also contain suitable pigments, fillers, resins or plasticisers.

The invention is illustrated further by the following examples.

Example 1

A solution of 1.2 g of 4-(2,2-diethoxyethoxy)styryl-3,4-dimethylthiazolium methosulphate in 10 g methanol was added to 50g of a 10% aqueous solution of "Gohsenol GH20" polyvinylalcohol, followed by 1 g of phosphoric acid. ("Gohsenol" is a Regd. Trademark; Gohsenol GH20 is a partially-hydrolysed polyvinylacetate of 88% hydrolysis and degree of polymerisation 2000.) The solution was stirred at 70 °C for 4 hours, followed by precipitation in a large volume of ethanol, to isolate an acetalised polyvinylalcohol derivative, which was washed with ethanol and then dried.

UV analysis of the polymer showed the presence of 1.55 mole % of styrylthiazole groups with $\lambda_{max}$ 374nm.

Three light-sensitive emulsions were prepared from this polymer, the emulsions having the compositions shown in Table 1, by blending the ingredients on a high shear mixer.

Table 1

| | A | B | C |
|---|---|---|---|
| styrylthiazole-substituted polyvinylalcohol | 1g | 1g | 1g |
| water | 10g | 10g | 10g |
| "Vinnapas" M50 (Regd. Trademark) | 4g | 4g | 10g |
| dibutylphthalate | 0.5g | 0.5g | 1.25g |
| ethoxylated trimethylolpropanetriacrylate | 1.5g | - | - |
| isopropylthioxanthone | 0.025g | - | - |
| ethyl-4-dimethylaminobenzoate | 0.05g | - | - |
| (Vinnapas M50 is a polyvinylalcohol-stabilised polyvinylacetate homopolymer of 50% solids.) | | | |

Each composition was coated on to both sides of a 90-threads per cm screenprinting mesh and dried. The three coatings were then exposed for 30 seconds through a photographic positive, using a 5kW mercury vapour lamp at 1 metre distance. After development with running water, negative images of the original were obtained, which were suitable for use as screenprinting stencils.

Each stencil was printed with the following inks:

"Texiscreen TS" a water-containing ink for textile printing.
"Polyplast PY" a solvent-containing ink for paper, board and plastics.
"Monotex" an ink containing water and organic solvent for textile printing.

After printing, the mesh was reclaimed by soaking in a 1% aqueous solution of sodium periodate followed by washing with a high pressure water spray. The results are summarised in Table 2.

Table 2

| Stencil | Stencil durability on printing with Texiscreen | Stencil durability on printing with Polyplast | Stencil durability on printing with Monotex | Mesh Reclaiming |
|---|---|---|---|---|
| A | Good, no damage | Good, no damage | Good, no damage | Easily cleaned |
| B | Poor, stencil softens and is damaged | Good, no damage | Poor, stencil softens and is damaged | Fair, leaves stain |
| C | Good, no damage | Poor, stencil softens and is damaged | Poor, stencil softens and is damaged | Poor, leaves heavy stain |

Example 2

A solution of 0.4 g of 4-(2,2-diethoxyethoxy)styryl-3-methylthiazolium methosulphate in 5 g of methanol was added to 50 g of a 10% aqueous solution of Gohsenol GH20 polyvinylalcohol, followed by 1 g of 4-toluenesulphonic acid. The solution was stirred at 70°C for 6 hours, followed by precipitation in a large volume of ethanol to isolate an acetalised polyvinylalcohol derivative, which was then washed in ethanol and dried.

UV analysis of the polymer showed the presence of 0.51 mole % of styrylthiazoline groups with $\lambda_{max}$ 360nm.

A photosensitive emulsion was prepared by blending the following components on a high shear mixer.

| | |
|---|---|
| styrylthiazoline substituted polyvinylalcohol | 3g |
| water | 30g |
| Vinnapaz EP400 | 6g |
| Unisperse Blue GP | 0.1g |
| (Vinnapas EP400 is a polyvinylalcohol-stabilised ethylene/vinylacetate copolymer.) | |

This composition was coated on to a 90 threads per cm screenprinting mesh and, whilst still wet, was laminated to a photographic positive.

The laminate was exposed to a 5kW mercury vapour lamp at 1m distance for 1 minute and the photographic positive removed. Development in running water, followed by drying, yielded a stencil suitable for use in screenprinting.

Example 3

The procedure of Example 2 was followed, except that 0.45 g of 3-(2,2-diethoxyethoxy)-4-methoxystyryl-3-4-dimethylthiazoliummethosulphate was used in place of the styrylbenzoxazole. UV analysis of the resultant polymer showed the presence of 0.46 mole % methoxystyrylthiazole groups with $\lambda_{max}$ 380nm.

A photosensitive composition was prepared by blending the following components on a high shear mixer.

| | |
|---|---|
| methoxystyrylthiazole substituted polyvinylalcohol | 3g |
| water | 30g |
| Vinnapaz M50 | 6g |

This composition was coated on to a polyethyleneterephthalate support and dried to give a light-sensitive coating of 20 µm thickness.

This dried coating was applied to a wet degreased screenprinting mesh of 165 threads per cm and the excess water removed with a window squeegee. After drying, the support was removed and the coating exposed to a 5kW mercury vapour lamp at 1 metre distance for 20 seconds through a photographic positive. After development with a strong spray of water, a stencil was obtained which was suitable for screenprinting.

**Claims**

1. A screenprinting photostencil comprising a support layer and a coating layer comprising a photosensitive emulsion containing a photodimerisable polyvinylalcohol derivative incorporating a photosensitive constituent of the formula:

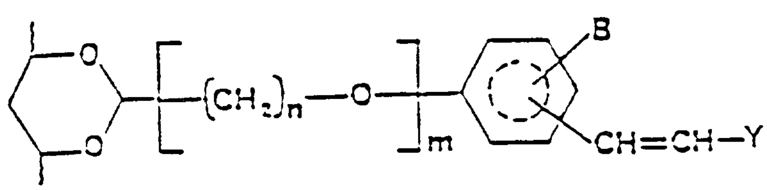

wherein

Y = 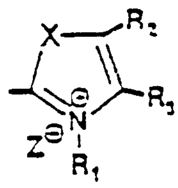 or 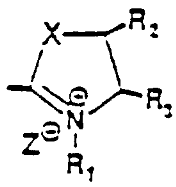

m = 0 or 1;
n = 0 or an integer from 1 to 6; subject to the proviso that when n = 0, then m = 0;
B = H or a tertiary amine, methoxy or ethoxy group;
X = 0, S or Se or an $NR_1$ or $C(R_1)_2$ group,
wherein $R_1$ = H or an alkyl, hydroxyalkyl, aryl or aralkyl group,
Z = an anion and
wherein $R_2$ and $R_3$ are the same or different and each represents H, halogen or an alkyl, hydroxyalkyl, aryl, nitro or cyano group or $R_2$ and $R_3$ taken together may form part of the same aliphatic ring system.

**2.** A screenprinting photostencil according to claim 1, wherein the photosensitive emulsion contains two or more polyvinylalcohol derivatives incorporating respective different constituents according to the stated formula.

**3.** A screenprinting photostencil according to claim 1 or 2, wherein the photosensitive emulsion also contains at least one further component selected from pigments, fillers, plasticisers and resins.

**4.** A screenprinting photostencil according to claim 3, wherein the filler comprises one or more of polyvinylacetate, polyethylene vinylacetate, polyacrylates, polystyrene, polybutadiene and polyvinylchloride.

**5.** A screenprinting photostencil according to any preceding claim, wherein the photosensitive emulsion also contains a photoinitiator which, under the effect of actinic light, produces free radicals capable of initiating vinyl polymerisation, together with a monomer containing two or more unsaturated groups capable of polymerisation.

**6.** A screenprinting photostencil according to any preceding claim, wherein the photodimerisable polyvinylalcohol derivative also incorporates, as a non-photosensitive modifier, at least one constituent introduced by reaction of a compound containing a formyl or an acetal group with hydroxyl groups of polyvinylalcohol backbone.

**7.** A screenprinting photostencil according to claim 6, wherein the said compound is selected from acetaldehyde, acetaldehyde dimethyl acetal, acetaledehyde diethyl acetal, chloral, chloracetaldehyde dimethyl acetal and chloracetaldehyde diethyl acetal.

**8.** A screenprinting photostencil according to any preceding claim, wherein the polyvinylalcohol derivative or mixture of derivatives is obtained from a partially or fully hydrolysed grade of polyvinylacetate.

**9.** A screenprinting photostencil according to claim 8, wherein the polyvinylalcohol derivative(s) is/are derivative(s) of polyvinylalcohol having a degree of hydrolysis of about 88%.

**10.** A screenprinting photostencil according to any preceding claim, wherein the photosensitive constituent of the stated formula is present in a concentration in the range from 0.46 to 3 mole %, based upon the polyvinylalcohol in the composition.

**11.** A screenprinting photostencil according to any preceding claim, wherein the support layer comprises a screenprinting screen.

**12.** A screenprinting photostencil according to any of claims 1 to 10, wherein the support layer comprises a temporary film support.

**Patentansprüche**

1. Siebdruckfotoschablone mit einer Stützschicht und einer Deckschicht, welche aus einer fotoempfindlichen Emulsion besteht und ein fotodimerisierbares Polyvinylalkoholderivat enthält, welches einen fotoempfindlichen Bestandteil der folgenden Formel aufweist

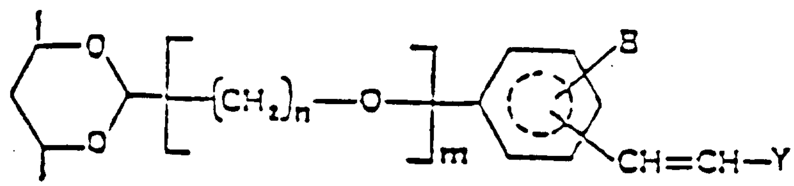

wobei

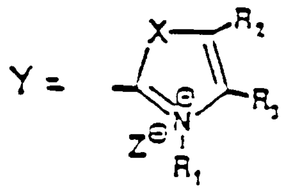

oder

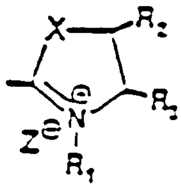

| | |
|---|---|
| m = | 0 oder 1; |
| n = | 0 oder eine ganze Zahl von 1 bis 6 in Abhängigkeit von der Bedingung, daß wenn n = 0, daß dann m = 0; |
| B = | H oder eine tertiäre Amin-, eine Methoxy- oder eine Äthoxygruppe ist; |
| X = | 0, S oder Se oder eine $NR_1$- oder $C(R_1)_2$-Gruppe ist, wobei $R_1$ = H oder eine Alkyl-, Hydroxyalkyl-, Aryl- oder Aralkylgruppe ist, |
| Z = | ein Anion ist und $R_2$ und $R_3$ einander gleich oder unterschiedlich sind und jeweils H, ein Halogen oder eine Alkyl-, Hydroxyalkyl-, Aryl-, Nitro- oder Cyangruppe darstellen oder wobei $R_2$ und $R_3$ zusammengenommen einen Teil des gleichen aliphatischen Ringsystems bilden können. |

2. Siebdruckfotoschablone nach Anspruch 1, wobei die fotoempfindliche Emulsion zwei oder mehr Polyvinylalkoholderivate umfaßt, welche jeweils unterschiedliche Bestandteile entsprechend der dargelegten Formel aufweisen.

3. Siebdruckfotoschablone nach Anspruch 1 oder 2, wobei die fotoempfindliche Emulsion ferner wenigstens eine weitere Komponente enthält, die aus der Gruppe Pigmente, Füllstoffe, Weichmacher und Harze ausgewählt ist.

4. Siebdruckfotoschablone nach Anspruch 3, wobei die Füllstoffe aus einem oder mehreren der folgenden Stoffe bestehen, nämlich Polyvinylacetat, Polyäthylenvinylacetat, Polyacrylate, Polystyrol, Polybutadien und Polyvinylchlorid.

5. Siebdruckfotoschablone nach einem der vorangegangenen Ansprüche, wobei die fotoempfindliche Emulsion auch einen Fotoinitiator aufweist, der unter der Wirkung aktinischen Lichtes freie Radikale erzeugt, die zur Initiierung der Vinylpolymerisation geeignet sind und zwar zusammen mit einem Monomer, welches zwei oder mehr ungesättigte, polymerisierbare Gruppen umfaßt.

6. Siebdruckfotoschablone nach einem der vorangegangenen Ansprüche, wobei das fotodimerisierbare Polyvinylalkoholderivat ferner als nicht fotoempfindliches Modifiziermittel wenigstens einen Bestandteil umfaßt, der durch Reaktion einer eine Formyl- oder eine Acetalgruppe enthaltenden Verbindung mit den Hydroxylgruppen des Polyvinylalkoholgerüstes eingeführt worden ist.

7. Siebdruckfotoschablone nach Anspruch 6, wobei die genannte Verbindung aus Acetaldehyd, Acetaldehyd-Dimethylacetal, Acetaldehyd-Diäthylacetal, Chloral, Chloracetaldehyd Dimethylacetal und Chloracetaldehyd-Diäthylacetal ausgewählt ist.

8. Siebdruckfotoschablone nach einem der vorangegangenen Ansprüche, wobei das Polyvinylalkoholderivat oder die Mischung von Derivaten aus einem teilweise oder völlig hydrolysierten Polyvinylacetat gewonnen ist.

9. Siebdruckfotoschablone nach Anspruch 8, wobei das/die Polyvinylalkoholderivat/Polyvinylalkoholderivate aus Polyvinylalkoholderivaten besteht/bestehen, die einen Hydrolysegrad von ungefähr 88% aufweisen.

10. Siebdruckfotoschablone nach einem der vorangegangenen Ansprüche, wobei der fotoempfindliche Bestandteil der dargestellten Formel in einer Konzentration zwischen 0,46 Mol-% bis 3 Mol-% gegenwärtig ist, bezogen auf den Polyvinylalkohol in der Verbindung.

11. Siebdruckfotoschablone nach einem der vorangegangenen Ansprüche, wobei die Stützschicht aus einem Siebdruck-Sieb besteht.

12. Siebdruckfotoschablone nach einem der vorangegangenen Ansprüche 1 bis 10, wobei die Stützschicht aus einem zeitweise nutzbaren Filmträger besteht.

**Revendications**

1. Photostencil pour sérigraphie, comprenant une couche de support et une couche de revêtement comprenant une émulsion photosensible, qui contient un dérivé photodimérisable du poly(alcool vinylique), et comprenant un constituant photosensible de formule :

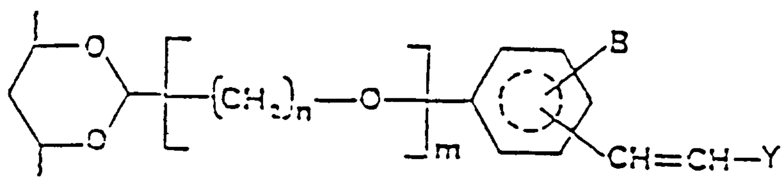

où

Y =

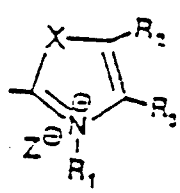

ou

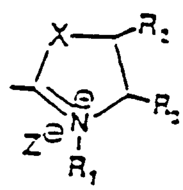

m = 0 ou 1 ;

n = 0 ou est un entier de 1 à 6, du moment que, quand n = 0, alors m = 0 ;

B = H ou est une amine tertiaire ou un groupe méthoxy ou éthoxy ;

X = 0, S ou Se ou est un groupe $NR_1$ ou $C(R_1)_2$, où $R_1$ = H ou un groupe alkyle, hydroxyalkyle, aryle ou aralkyle,

Z est un anion, et

où $R_2$ et $R_3$ sont identiques ou différents et représentent chacun H ou un groupe halogéno ou alkyle, hydroxyalkyle, aryle, nitro ou cyano, ou encore $R_2$ et $R_3$, pris ensemble, peuvent former une partie du même système cyclique aliphatique.

2. Photostencil pour sérigraphie selon la revendication 1, dans lequel l'émulsion photosensible contient au moins deux dérivés de poly(alcool vinylique) comprenant des constituants différents selon la formule ci-dessus.

3. Photostencil pour sérigraphie selon la revendication 1 ou 2, dans lequel l'émulsion photosensible contient aussi au moins un autre composant choisi parmi les pigments, les charges, les plastifiants et les résines.

4. Photostencil pour sérigraphie selon la revendication 3, dans lequel la charge comprend un ou plusieurs des composés suivants : poly(acétate de vinyle), copolymère d'éthylène et d'acétate de vinyle, polyacrylates, polystyrène, polybutadiène et poly(chlorure de vinyle).

5. Photostencil pour sérigraphie selon l'une quelconque des revendications précédentes, dans lequel l'émulsion photosensible contient aussi un photoamorceur qui, sous l'effet d'une lumière actinique, produit des radicaux libres capables d'amorcer une polymérisation vinylique, en même temps qu'un monomère contenant au moins deux groupes insaturés polymérisables.

6. Photostencil pour sérigraphie selon l'une quelconque des revendications précédentes, dans lequel le dérivé photodimérisable du poly(alcool vinylique) comprend aussi, comme modifiant non photosensible, au moins un constituant introduit par la réaction d'un composé contenant un groupe formyle ou acétal avec des groupes hydroxyle de l'ossature du poly(alcool vinylique).

7. Photostencil pour sérigraphie selon la revendication 6, dans lequel le composé est choisi parmi l'acétaldéhyde, l'acétal diméthylique de l'acétaldéhyde, l'acétal diéthylique de l'acétaldéhyde, le chloral, l'acétal diméthylique du chloracétaldéhyde et l'acétal diéthylique du chloracétaldéhyde.

8. Photostencil pour sérigraphie selon l'une quelconque des revendications précédentes, dans lequel le dérivé du poly(alcool vinylique) ou le mélange de dérivés est obtenu à partir d'une qualité de poly-(acétate de vinyle) partiellement ou complètement hydrolysée.

9. Photostencil pour sérigraphie selon la revendication 8, dans lequel le ou les dérivés du poly(alcool vinylique) sont des dérivés du poly(alcool vinylique) ayant un degré d'hydrolyse d'environ 88 %.

10. Photostencil pour sérigraphie selon l'une quelconque des revendications précédentes, dans lequel le constituant photosensible ayant la formule ci-dessus est présent selon une concentration comprise entre 0,46 et 3 % en moles par rapport au poly(alcool vinylique) se trouvant dans la composition.

11. Photostencil pour sérigraphie selon l'une quelconque des revendications précédentes, dans lequel la couche support comprend un écran de sérigraphie.

12. Photostencil pour sérigraphie selon l'une quelconque des revendications 1 à 10, dans lequel la couche support comprend un support pelliculaire provisoire.